# NOUVEAU FASCICULE DE BREVET EUROPEEN

(11) **EP 2 237 950 B2**
(45) Date de publication et mention de la décision concernant l'opposition: **13.01.2016**
(45) Mention de la délivrance du brevet: 21.09.2011
(21) Numéro de dépôt: 09709562.4
(22) Date de dépôt: 06.02.2009
(51) Int. Cl.: B32B 27/08, B32B 27/28, B32B 27/30, H01L 31/048, C08L 27/16, C08L 33/12

(54) **FILM TRICOUCHE POUR CELLULE PHOTOVOLTAÏQUE**
DREISCHICHTIGER FILM FÜR EINE PHOTOVOLTAISCHE ZELLE
THREE-LAYER FILM FOR A PHOTOVOLTAIC CELL

(30) Priorité: 06.02.2008 FR 0850756; 08.04.2008 US 43229 P
(43) Date de publication de la demande: 13.10.2010
(73) Titulaire: ARKEMA FRANCE, 92700 Colombes (FR)
(72) Inventeur: BIZET, Stéphane, F-27170 Barc (FR); BONNET, Anthony, F-27170 Beaumont Le Roger (FR); DEVAUX, Nicolas, 69003 Lyon (FR); LAFFARGUE, Johann, F-27300 Plasnes (FR); LAPPRAND, Aude, 75011 Paris (FR)
(74) Mandataire: Albani, Dalila
(86) Numéro de dépôt international: PCT/FR2009/050190
(87) Numéro de publication internationale: WO 2009/101343

(56) Documents cités:
- EP-A- 0 733 475
- WO-A-2007/085769
- WO-A1-2007/087055
- WO-A2-2005/081859
- WO-A2-2007/078972
- US-A- 5 132 164
- ANONYMOUS: "Polyvinylidene fluoride - Typical properties" INTERNET ARTICLE ( SOLEF & HYLAR PVDF), [Online] XP002491818 Extrait de l'Internet: URL:http://www.solvaysolexis.com/static/wm a/pdf/9/2/2/4/TR_Solef_Hylar.pdf> [extrait le 2008-08-11]
- ASTM D 1003 -07 "Standard Test Method for Haze and Luminous Transmittance of Transparent Plastics" (Novembre 2007)
- ISO 11501 "Plastics - Film and sheeting - Determination of dimensional change onheating" (15.09.1995)
- Technical Data Sheet of Solef® PVDF 1010 (2003)
- Technical Brochure Cast & Extruded Sheet Altuglas® (Février 2005)
- DuPont TM Ti-Pure® (2007)
- Sample dispersion & refractive index guide

## Description

### [Domaine de l'invention]

La présente invention concerne un film multicouche de structure A/B/C à base de polymères de fluorure de vinylidène (VDF) utilisable notamment dans le domaine des cellules photovoltaïques.

### [Le problème technique]

Des polymères fluorés en général et notamment le PVDF (polyfluorure de vinylidène) en raison de sa très bonne résistance aux intempéries, au rayonnement et aux produits chimiques est un polymère utilisé pour protéger les objets et matériaux. Les polymères de VDF sont aussi appréciés pour leur aspect brillant et leur résistance aux graffitis. On est donc amené à revêtir toutes sortes d'objets avec un film polymérique à base de VDF. Cependant, il est nécessaire que ce film présente une très bonne résistance thermique pour des applications extérieures soumises à des conditions climatiques sévères (pluie, froid, chaud) ou des procédés de transformation réalisés à haute température (>130°C). Il est nécessaire aussi que le film présente une bonne flexibilité et une bonne résistance à la rupture de façon à résister aux sollicitations mécaniques lors de la pose du film sur l'objet ou le matériau à recouvrir ou une fois le film déposé sur l'objet ou le matériau, un test applicatif classiquement utilisé consiste à déchirer un film qui a subi un vieillissement en étuve puis voir si la déchirure se propage facilement ou pas.

Dans une cellule photovoltaïques la protection contre l'environnement est absolument requise. Pour cette raison la partie arrière de la cellule doit être protéger pour éviter la dégradation de celle-ci par des rayons ultra violet (UV) et la pénétration d'humidité. Cette dégradation peut consister en une oxydation du film protecteur du panneau arrière de la cellule. En outre, le panneau arrière de la cellule doit être un isolant électrique.

En outre le film doit avoir une stabilité thermique en volume pour éviter une expansion thermique et en particulier un retrait pendant l'assemblage des cellules. L'assemblage des cellules photovoltaïques est fait par collage des différentes couches à l'aide d'un adhésif à base solvant, suivi par un laminage. L'utilisation de solvants dans les adhésifs peut provoquer une pénétration de ces solvants dans le film. L'assemblage des cellules est réalisé à haute température (>130°C) et éventuellement à l'aide d'un traitement d'oxydation de surface de type Corona, qui se traduit notamment par un jaunissement et une dégradation des propriétés mécaniques du polymère fluoré.

La Demanderesse a mis au point une structure sous forme d'un film à base de polymère fluoré qui présente une bonne résistance thermique (faible retrait en volume lorsqu'il est soumis à des températures élevées) ainsi qu'une excellente résistance aux solvants présents dans les colles et adhésifs utilisés pour la construction des cellules photovoltaïques, et plus particulièrement du panneau arrière des cellules. Cette structure est donc parfaitement bien adaptée pour protéger le panneau arrière des cellules photovoltaïque.

Ce film présente une structure particulière de type A/B/C. Cette structure selon l'invention est opaque (faible transmission de la lumière visible et des rayons UV) et présente en autre une protection contre la pénétration à l'oxygène La structure garde un bel aspect esthétique de film (pas de jaunissement au cours de temps).

### [L'art antérieur]

La demande EP 1382640 décrit un film à deux ou trois couches à base d'un homo- ou copolymère de VDF. Le copolymère en VDF comprend de 0 à 50% en masse de comonomère. Dans les exemples seule l'utilisation d'un homopolymère de PVDF est décrite. Un absorbeur UV organique est aussi précisé dans les exemples.

La demande EP 1566408 décrit un film à deux ou trois couches à base de homo-ou copolymère de VDF. Le copolymère de VDF comprend de 0 à 50% en masse de comonomère, avantageusement de 0 à 25% et de préférence de 0 à 15%. Le film ne contient aucune charge minérale.

La demande internationale WO 2005/081859 décrit des films multicouches à base de polymère fluoré et de polymère acrylique.

La demande US 200510268961 décrit une cellule photovoltaïque protégée par un film comprenant deux couches de polymère fluoré, l'une ayant une température de fusion supérieure à 135°C, l'autre ayant une température de fusion inférieure à 135°C.

La demande US 2005/0172997 et le brevet US 6369316 décrivent un module photovoltaïque protégé par un film en polyfluorure de vinyle (PVF).

La demande internationale WO 2007/011580 décrit des films à base de polyester pour panneau arrière d'une cellule photovoltaïque. Une couche de polyfluorure de vinyle (PVF) peut être associée au film de polyester. Le panneau arrière est évalué uniquement du point de vu de la pénétration à l'humidité.

Le brevet US 5 132 164 décrit un film multicouhe, comprenant une couche de composition A, qui comprend de 50 à 95 parties en poids d'une résine à base de VDF et de 5 à 50 parties en poids d'une résine méthacrylate, et une couche de composition B, qui comprend de 50 à 95 parties de résine méthacrylate, de 5 à 50 parties en poids d'un PVDF et de 0,1 à 15 parties en poids d'un absorbeur UV.

Aucun de ces documents ne fait référence à une structure multicouche ayant les mêmes caractéristiques que celle de l'invention et rien ne permet dans ces documents de conduire l'homme du métier à une telle structure.

### [Résumé de l'invention]

L'invention est relative à un film multicouche de structure A/B/C tel que défini dans la revendication 1.

L'invention a aussi pour objectif l'utilisation de ce film multicouche dans une cellule photovoltaïque, un textile technique ou pour recouvrir un métal.

Plus particulièrement l'invention porte sur une cellule photovoltaïque dont le panneau arrière est revêtu d'un film multicouche tel que décrit précédemment.

### [Description détaillée]

Dans la description « compris entre x et y » signifie que les bornes x et y sont comprises.

L'invention est relative à un film multicouche de structure A/B/C tel que défini dans la revendication 1.

Par « parties », on entend au sens de l'invention des parties massiques.

Dans le cas où la composition A de la première couche est identique à la composition C de la troisième couche, alors la structure se présente sous forme d'un film multicouche symétrique A/B/A.

L'épaisseur de chacune des couches de composition A et C peut, de manière indépendante l'une de l'autre, et en pratique, être comprise entre 1 et 30 µm, avantageusement entre 2 et 20 µm, préférentiellement entre 3 et 18 µm et de manière encore plus préférée entre 5 et 15µm.

Dans une variante de l'invention, les épaisseurs des couches de composition A et C sont identiques.

Dans une autre variante de l'invention, les compositions A et C de ces premières et troisièmes couches sont identiques.

L'épaisseur de la couche de composition B est notamment comprise entre 4 et 45 µm, avantageusement entre 5 et 40µm, préférentiellement entre 7 et 30µm et de manière encore plus préférée entre 10 et 25µm.

S'agissant du polymère fluoré, celui-ci est préparé par polymérisation d'un ou plusieurs monomère(s) de formule (I) : 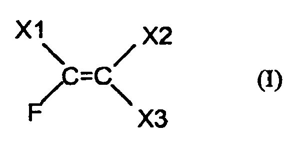 dans laquelle :
- X₁ désigne H ou F ;
- X₂ et X₃ désignent H, F, Cl, un groupement alkylé fluoré de formule CₙFₘHₚ- ou un groupement alcoxy fluoré CₙFₘHₚO-, n étant un entier compris entre 1 et 10, m un entier compris entre 1 et (2n+1), p valant 2n+1-m.

Comme exemples de monomères on peut citer l'hexafluoropropylène (HFP) le tétrafluoroéthylène (TFE), le fluorure de vinylidène (VDF, CH₂=CF₂), le chlorotrifluoroéthylène (CTFE), les éthers vinyliques perfluoroalkyle tels que CF₃-O-CF=CF₂, CF₃-CF₂-O-CF=CF₂ ou CF₃-CF₂CF₂-O-CF=CF₂, le 1-hydropentafluoropropène, le 2-hydro-pentafluoropropène, le dichlorodifluoroéthylène, le trifluoroéthylène (VF₃), le 1,1-dichlorofluoroéthylène et leurs mélanges.

La polymérisation peut aussi éventuellement inclure d'autres monomères insaturés oléfiniques ne comportant pas de fluor tels que l'éthylène, le propylène, le butylène et les homologues supérieurs. Des dioléfines contenant du fluor peuvent aussi être utilisées, par exemple les dioléfines telles que l'éther perfluorodiallyle et le perfluoro-1,3-butadiène.

A titre d'exemples de polymères fluorés, on peut citer :
- les homo- ou copolymères du TFE, notamment le PTFE (polytétrafluoroéthylène), l'ETFE (copolymère éthylène-tétrafluoroéthylène) ainsi que les copolymères TFE/PMVE (copolymère tetrafluoroéthylène- perfluoro(méthyl vinyl)éther), TFE/PEVE (copolymère tetrafluoroéthylène- perfluoro(éthyl vinyl) éther), TFE/PPVE (copolymère tetrafluoroéthylène- perfluoro(propyl vinyl) éther), E/TFE/HFP (terpolymères éthylène-tétrafluoroéthylène - hexafluoropropylène) ;
- les homo- ou copolymères du VDF, notamment le PVDF et les copolymères VDF-HFP ;
- les homo- ou copolymères du CTFE, notamment le PCTFE (polychlorotrifluoroéthylène) et l'E-CTFE (copolymère éthylènechlorotrifluoroéthylène).

Le polymère fuoré est un homopolymère ou un copolymère de VDF.

Avantageusement, le comonomère fluoré copolymérisable avec le VDF est choisi par exemple parmi le fluorure de vinyle; le trifluoroéthylène (VF3); le chlorotrifluoethylène (CTFE); le 1,2-diftuoroéthylène; le tetraftuoroéthylène (TFE); l'hexafluoropropylène (HFP); les perfluoro(alkyl vinyl) éthers tels que le perfluoro(méthyl vinyl)éther (PMVE), le perfluoro(éthyl vinyl) éther (PEVE) et le perfluoro(propyl vinyl) éther (PPVE); le perfluoro(1,3-dioxole); le perfluoro(2,2-diméthyl-1,3-dioxole) (PDD), et leur mélanges.

De préférence le comonomère fluoré est choisi parmi le chlorotrifluoroéthylène (CTFE), l'hexafluoropropylène (HFP), le trifluoroéthylène (VF3) et le tétrafluoroéthylène (TFE), et leur mélanges.

Le comonomère est avantageusement l'HFP car il copolymérise bien avec le VDF et permet d'apporter de bonnes propriétés thermomécaniques. De préférence, le copolymère ne comprend que du VDF et de l'HFP.

Avantageusement, le homopolymère ou un copolymère de VDF ont une viscosité allant de 100 Pa.s à 3000 Pa.s, la viscosité étant mesurée à 230°C, à un gradient de cisaillement de 100 s⁻¹ à l'aide d'un rhéomètre capillaire. En effet, ce type de polymère est bien adapté à l'extrusion. De préférence, le polymère a une viscosité allant de 500 Pa.s à 2900 Pa.s, la viscosité étant mesurée à 230°C, à un gradient de cisaillement de 100 s⁻¹ à l'aide d'un rhéomètre capillaire.

Le polymère fluoré est un homopolymère de VDF (PVDF) ou un copolymère de VDF comme VDF-HFP contenant au moins 50% en masse de VDF, avantageusement au moins 75% en masse de VDF et de préférence au moins 90% en masse de VDF. Ce polymère fluoré présente en effet une bonne résistance chimique, notamment aux UV, et il se transforme facilement (plus facilement que le PTFE ou les copolymères ETFE) en vue de former des films. On peut citer par exemple plus particulièrement le homopolymères ou copolymères de VDF contenant plus de 75% de VDF et le complément de HFP suivants: KYNAR^{®} 710, KYNAR^{®} 720, KYNAR^{®} 740, KYNAR FLEX^{®} 2850, KYNAR FLEX^{®} 3120, commercialisés par la société ARKEMA.

S'agissant du polymère fluoré de la composition A et/ou de la composition C, on utilise les homopolymères du fluorure de vinylidène (VDF, CH₂=CF₂) (PVDF) et les copolymères du VDF contenant de préférence au moins 90 % en masse de VDF.

Dans une autre variante de l'invention la composition A et C contient de l'homopolymère PVDF.

Les produits Kynar® de la société ARKEMA sont particulièrement recommandés, comme par exemple les produits de la série Kynar® 700 (homopolymère de VDF) ou certains Kynar Flex® (copolymère de VDF) contenant moins de 5% de comonomères distribués de façon statistique, ou moins de 10% de comonomères si le copolymère obtenu présente une structure hétérogène ou en bloc avec un point de fusion supérieur à 150°C et de préférence supérieur à 160°C. Ces polymères fluorés présentent entre autre l'avantage d'un point fusion élevé allant de 150°C à 300°C.

**S'agissant du polymère fluoré de la composition B,** on utilise les homopolymères du fluorure de vinylidène (VDF, CH₂=CF₂) (PVDF) et les copolymères du VDF contenant de préférence au moins 85 % en masse de VDF.

Les produits Kynar® de la société ARKEMA sont particulièrement recommandés, comme par exemple les produits de la série 700 (homopolymère de VDF) ou certains Kynar Flex® (copolymère de VDF) contenant moins de 15% (valeur compris) massique de comonomère, avantageusement moins de 13% (valeur compris) massique de comonomère, préférentiellement au plus à 11 % et de manière encore plus préférée au plus à 10% ; et présentent un point de fusion supérieur à 140°C, de préférence supérieure à 150°C, avantageusement supérieur à 160°C et préférentiellement inférieure à 300°C.

Le comonomère est avantageusement l'HFP car il copolymérise bien avec le VDF et permet d'apporter de bonnes propriétés thermomécaniques. De préférence, le copolymère ne comprend que du VDF et de l'HFP ; la teneur en comonomère varie de 0,5% à 15% massique, de préférence de 3% à 13% massique et par exemple de 6 à 10% massique.

La couche de composition B selon l'invention contient de 30 à 75 parties d'un homopolymére ou copolymère de VDF de 5 à 45 parties d'un homopolymère ou copolymère de MMA et de 10 à 30 parties d'au moins une charge minérale, le total faisant 100 parties.

Cette couche de composition B appelée aussi couche fonctionnelle est opaque aux UV et à la lumière visible. Opaque veut dire que la transmittance au rayon UV et à la lumière visible est inférieure à une certaine valeur ou pourcentage pour une épaisseur donnée en comparaison avec une structure de type A/B/C, qui ne contient pas des « charges » notamment minérales dans la composition de la couche B. Cette structure A/B/C présente des avantages importants par rapport aux structures d'art antérieur en terme de retrait dimensionnel en température et les couches des compositions A et C permettent de protéger la couche B des dégradations du fluoropolymère, grâce à l'action combinée de la charge par exemple minérale, de l'oxygène et de la température, ou sous l'action de tout traitement surfacique oxydatif de type Corona en présence de charge minérale.

**S'agissant du polymère de MMA,** on utilise avantageusement les homopolymères du méthacrylate de méthyle (MMA) et les copolymères contenant au moins 50% en masse de MMA et au moins un autre monomère copolymérisable avec le MMA.

A titre d'exemple de comonomère copolymérisable avec le MMA, on peut citer par exemple les (méth)acrylates d'alkyle, l'acrylonitrile, le butadiène, le styrène, l'isoprène. Des exemples de (méth)acrylates d'alkyle sont décrits dans KIRK-OTHMER, Encyclopedia of chemical technology, 4ème édition (1991) dans le Vol. 1 pages 292-293 et dans le Vol. 16 pages 475-478.

Avantageusement, le polymère (homopolymère ou copolymère) de MMA comprend en masse de 0 à 20% et de préférence 5 à 15% d'un (méth)acrylate d'alkyle en C₁-C₈, qui est de préférence l'acrylate de méthyle et/ou l'acrylate d'éthyle. Le polymère (homopolymère ou copolymère) de MMA peut être fonctionnatisé, c'est-à-dire qu'il contient par exemple des fonctions acide, chlorure d'acide, alcool, anhydride. Ces fonctions peuvent être introduites par greffage ou par copolymérisation. Avantageusement, la fonctionnalité est en particulier la fonction acide apportée par le comonomère acide acrylique. On peut aussi utiliser un monomère à deux fonctions acide acrylique voisines qui peuvent se déshydrater pour former un anhydride. La proportion de fonctionnalité peut être de 0 à 15% en masse du polymère de MMA par exemple de 0 à 10% en masse..

Le polymère de MMA peut contenir avantageusement au moins un additif modifiant choc. Il existe des qualités commerciales de polymère de MMA dit résistant aux chocs, qui contiennent un additif modifiant choc acrylique sous forme de particules multicouches. L'additif modifiant choc est alors présent dans le polymère de MMA tel qu'il est commercialisé (c'est-à-dire introduit dans la résine de MMA au cours du procédé de fabrication) mais il peut aussi être ajouté lors de la fabrication du film. La proportion d'additif modifiant choc varie de 0 à 30 parts pour 70 à 100 parts de polymère de MMA, le total faisant 100 parts.

Les additifs modifiant choc du type particules multicouches, appelées aussi couramment core-shell (noyau-écorce), comprennent au moins une couche élastomérique (ou molle), c'est-à-dire une couche formée d'un polymère ayant une température de transition vitreuse (Tg) inférieure à -5°C et au moins une couche rigide (ou dure), c'est-à-dire formée d'un polymère ayant une Tg supérieure à 25°C. La taille des particules est en général inférieure au µm et avantageusement comprise entre 50 et 300 nm. On trouvera des exemples d'additif modifiant choc sous forme de particules multicouches de type core-shell dans les documents suivants: EP 1061100 A1**,** US 2004/0030046 A1**,** FR-A-2446296 ou US 200510124761 A1**.** On préfère des particules de type core-shell ayant au moins 80% en masse de phase élastomérique molle.

Le MVI (melt volume index ou indice de fluidité en volume à l'état fondu) du polymère de MMA peut être compris entre 2 et 15 cm³/10 min, mesuré à 230°C sous une charge de 3,8 kg.

La teneur en polymère de MMA dans la composition B est comprise entre 1 et 55% massique, avantageusement entre 5 et 50% massique, préférentiellement entre 10 et 45% massique et de manière encore plus préférée entre 20 et 40% massique.

**S'agissant de la charge minérale**, on utilise le dioxyde de titane (TiO₂).

La charge minérale a une fonction d'opacifiant dans le domaine de l'UV/visible. L'action protectrice de la charge est complémentaire de celle de l'absorbeur UV.

La charge minérale joue le rôle de filtres solaires pour avoir un film opaque, principalement par diffusion/réflexion des rayons UV, mais également à la lumière visible.

La charge a une taille exprimée en diamètre moyen généralement comprise entre 0,05 µm et 1 mm, avantageusement entre 0,1µm et 700µm, préférentiellement entre 0,2µm et 500µm. La teneur en charge minérale dans la composition B est comprise entre 0,1 et 30% massique, avantageusement entre 5 et 28% massique, préférentiellement entre 10 et 27% massique et de manière encore plus préférée entre 15 et 25% massique.

### S'agissant du film à base de polymère fluoré,

Le film à base de polymère fluoré est à base d'un homopolymère ou un copolymère de VDF, et il a une structure de type A/B/C. De préférence, l'homopolymère ou copolymère de VDF de la composition A et/ou C est un homopolymère de VDF.

Le film à base d'un homopolymère et/ou un copolymère de VDF, qui protège le substrat comprend donc dans l'ordre à partir du substrat une couche de composition A ou C, une couche de composition B, une couche de composition A ou C, le film adhérant sur le substrat par une couche adhésive.

Dans le cas où la composition A de la première couche est identique à la composition C de la troisième couche, alors la structure se présente sous forme d'un film multicouche symétrique A/B/A.

L'épaisseur de chacune des couches de composition A et C peut, de manière indépendante l'une de l'autre, et en pratique, être comprise entre 1 et 30 µm, avantageusement entre 2 et 20 µm, préférentiellement entre 3 et 18 µm et de manière encore plus préférée entre 5 et 15µm.

Dans une variante de l'invention, les épaisseurs des couches de composition A et C sont identiques.

Dans une autre variante de l'invention les compositions A et C de ces premières et troisièmes couches sont identiques.

L'épaisseur de la couche de composition B est notamment comprise entre 4 et 45 µm, avantageusement entre 5 et 40µm, préférentiellement entre 7 et 30 µm et de manière encore plus préférée entre 10 et 25µm.

Dans le cas où la composition A de première couche est identique à la composition C de troisième couche, le film multicouche a une structure symétrique A/B/A. Dans ce cas le film à base de PVDF qui protège le substrat comprend donc dans l'ordre à partir du substrat une couche de composition A, une couche de composition B, une couche de composition A, le film adhérant sur le substrat par une couche adhésive.

Une structure de type A/B/A n'implique pas du tout, que les deux couches A ont la même épaisseur.

### Fabrication des films à base de polymère fluoré

Le film à base d'un homopolymère ou copolymère de VDF est de préférence fabriqué par la technique de coextrusion par exemple par soufflage, mais il est également possible d'utiliser l'extrusion cast ou une technique de mise en oeuvre par voie solvant ou bien en utilisant la technique de plaxage.

### [Utilisations du film]

On décrit maintenant plus en détails les utilisations du film à base d'un homopolymère ou copolymère de VDF.

### comme film protecteur pour arrière de cellule photovoltaïque

Les cellules photovoltaïques peuvent être protégées à l'arrière par le film à base d'un homopolymère ou copolymère de VDF. Une cellule photovoltaïque permet de convertir l'énergie lumineuse en courant électrique. Généralement, une cellule photovoltaïque comprend des cellules photovoltaïques montées en série et reliées entres elles par des moyens de connection électrique. Les cellules photovoltaïques sont généralement mono jonction fabriquées à base de silicium multi-cristallin dopé "P" avec du bore lors de la fusion du silicium et dopées "N" avec du phosphore sur leur surface éclairée. Ces cellules sont mises en place dans un empilage laminé. L'empilage laminé peut être constitué d'EVA (copolymère éthylène-acétate de vinyle) enrobant les cellules photovoltaïques pour protéger le silicium de l'oxydation et de l'humidité. L'empilage est imbriqué entre une plaque de verre qui sert de support d'un côté et il est protégé par un film de l'autre côté. Le module photovoltaïque est ainsi protégé contre le vieillissement (UV, brouillard salin,...), contre les rayures, l'humidité ou la vapeur d'eau

La cellule est généralement protégée par une structure multicouche commercialisée sous la marque AKASOL^{®} ou ICOSOLAR^{®} qui est une association d'un film de TEDLAR^{®} (polyfluorure de vinyle ou PVF) et d'une feuille de PET (poly éthylène terephtelate).

La Demanderesse a constaté qu'il est possible d'utiliser avantageusement pour cette application une structure à base d'un film ou un film symétrique à base d'un homopolymère ou copolymère de VDF tel que défini précédemment à la place du film de TEDLAR^{®}.

Ce film de structure A/B/C ou A/B/A présente des avantages importants en terme de retrait dimensionnel en température et les couches de la composition A et C permettent de protéger la couche fonctionnelle B de dégradation du fluoropolymère sous l'action combinée de la charge minérale par exemple de type TiO₂, de l'oxygène et de la température ; ou encore de tout traitement de type corona en présence de charge minérale par exemple de type TiO₂.

Le retrait dimensionnel doit en effet être le plus faible possible pendant la phase de laminage sur le substrat par exemple une feuille de PET. Egalement le retrait dimensionnel doit être le plus faible possible pendant l'assemblage des panneaux réalisé à haute température (140 à 155°C) sous vide, ce afin de conserver la structure du film à base d'un homopolymère ou copolymère de VDF ; et notamment les épaisseurs de chacune des couches et donc l'intégrité des propriétés mécaniques, optiques et de résistance au vieillissement. Cette propriété est apportée par la structure A/B/C ou la structure symétrique A/B/A (qui garantit une planéité du film) et par la tenue en température de chacune des couches composant le film.

Dans le cas d'un film par exemple extrudé le retrait dimensionnel est surtout estimé par le retrait linéaire dans le sens d'extrusion et dans le sens transverse à l'extrusion. Le retrait volumique ou dimensionnel de film à 150°C est notamment inférieur à 2%, avantageusement inférieur à 1,5%, préférentiellement inférieur à 1% et de manière encore plus préférée inférieur à 0,5%.

La présence en teneur élevée de charge minérale par exemple de type TiO₂ peut entraîner sous l'action combinée de la température, de l'oxygène et des radiations UV la dégradation d'un polymère fluoré tel que les homopolymères ou copolymères de VDF. Cette oxydation se traduit notamment par un jaunissement et une dégradation des propriétés mécaniques. Les deux couches de la composition A et C en polymère de VDF sont donc nécessaires afin de protéger la couche fonctionnelle en composition B non seulement lors du laminage sur le substrat (via une couche adhésive) pour former le panneau arrière mais aussi lors de l'assemblage du panneau, réalisé à haute température et éventuellement suite à un traitement d'oxydation de surface de type Corona.

La couche en composition A ou C située à l'arrière de cellule photovoltaïque assemblé apporte de plus une résistance chimique accrue par rapport à celle de la couche B, ainsi qu'une meilleure résistance aux vieillissements sous UV.

La seconde couche de composition B, comprend de 30 à 75 parties d'au moins un homopolymère ou copolymère de VDF, de 5 à 45 parties d'au moins un homopolymère ou copolymère de MMA et de 10 à 30 parties d'au moins une charge minérale, le total faisant 100 parties

Le film décrit précédemment (abrégé film PVDF) est ensuite laminé de chaque côté d'un substrat de type PET, en utilisant tout type d'adhésif et de technologie de laminage connu de l'homme de métier. La structure finale du panneau arrière du module photovoltaïque est donc :
Film PVDF/Adhésif/PET/Adhésif/Film PVDF

Les adhésifs qui sont utilisés à titre exemplaire sont des formulations de polyester ou des polyuréthanes contenant du methylethyl cetone (MEC) ou du toluène.

### comme film protecteur de substrats souples

Le film à base d'un homopolymère ou copolymère de VDF peut aussi servir à protéger un substrat souple comme par exemple un textile technique (en PVC, tissu de verre, mat de verre, en aramide, en Kevlar,...). Une bâche en PVC constitue un exemple de substrat souple en PVC. Le film à base d'un homopolymère ou copolymère de VDF peut être appliqué via une couche adhésive à l'aide de la technique de laminage.

La présence de deux couches de composition A à base d'un homopolymère ou copolymère de VDF permet une protection contre une dégradation de la couche de composition B lors de la laminage et aussi une résistance chimique et au vieillissement sous UV accrue de la structure finale.

### comme film protecteur d'une feuille de métal

Le film à base d'un homopolymère ou copolymère de VDF peut aussi servir à protéger un substrat métallique comme par exemple l'acier, le cuivre ou l'aluminium. Le film à base d'un homopolymère ou copolymère de VDF peut être appliqué via une couche adhésive à l'aide de la technique de laminage.

### [Tests] :

Opacité UV : L'opacité UV est évaluée par des mesures d'absorbance en transmission dans le domaine spectral de l'UV à l'aide d'un spectrophotomètre.

Transmittance selon la norm ASTM D1003 : Les mesures de transmittance dans le domaine du visible sont effectuées à l'aide d'un spectrocolorimètre selon la norme ASTM D1003 avec l'illuminant D65 et avec un angle de 2°. Les valeurs de transmittance correspondent à une moyenne sur la gamme spectrale allant de 400 à 740 nm.

Le test de résistance chimique à la MEC est réalisé selon la norme EN 438-2:2000. La méthode consiste à déposer 2 à 3 gouttes de méthyl éthyl cétone sur le film à température ambiante et de recouvrir avec un verre de montre pendant 16 heures. Le verre de montre est ensuite retiré et la tache est lavée avec de l'eau contenant du savon puis rincée à l'eau déminéralisée. Une heure après le nettoyage la tache est examinée.

La notation du film se fait selon l'échelle d'évaluation suivante :
Degré 5 Pas de changement visible.
Degré 4 Faible changement de brillance et/ou de couleur seulement visible sous certains angles.
Degré **3** : Changement modéré de brillance et/ou de couleur.
Degré **2** : Changement important de brillance et/ou de couleur.
Degré 1: Dégradation superficielle et/ou cloquage.

Differential Scanning Thermographie (DSC) est fait selon la norme ISO 11357-3. Le pic de thermogramme obtenue indique la température de fusion Tf de la composition de chacune des couches dans la structure. Elle a été prise comme indication sur la résistance thermique.

Le retrait est mesuré selon la norme ISO 11501. Un morceau de film carré de 12*12 cm² dans lequel un carré de 10*10 est dessiné. Il est placé 10 minutes dans une étuve ventilée à 150°C. Ensuite, les dimensions du cadre sont de nouveau mesurées. Le retrait est alors évalué par la variation de chacune des dimensions rapportée à la dimension initiale. La valeur retenue est la valeur la plus importante.

### [Exemples]

### Produits utilisés

**PVDF-1:** PVDF homopolymère sous forme de granulés de MFI (Melt Flow Index ou indice de fluidité massique à l'état fondu) 10 g/10 min (230°C, 12.5 kg) ayant une viscosité de 1900 mPa s à 230°C, 100 s⁻¹ et une température de fusion d'environ 165°C.
PVDF-2 : copolymère VDF/HFP sous forme de granulés (11% HFP en poids) de MFI 5 g/10 min (230°C, 12.5 kg), ayant une viscosité de 2500 mPa s à 230°C, 100 s⁻¹ et une température de fusion de 142°C
PVDF-3: copolymère hétérogène VDF/HFP sous forme de granulés (10% HFP en poids) de MFI 5 g/10 min (230°C, 12.5 kg), ayant une viscosité de 2300 mPa s à 230°C, 100 s⁻¹ et une température de fusion de 163°C
**PVDF-4**: copolymère VDF/HFP sous forme de granulés (17% HFP en poids) de MFI 10 g/10 min (230°C, 12.5 kg), ayant une viscosité de 2200 mPa s à 230°C, 100 s⁻¹ et une température de fusion de 135°C.
**PMMA** : OROGLAS^{®} BS8 de la société ALTUGLAS INTERNATIONAL de MFI 4,5 g/10 min (230°C, 3,8 kg) sous forme de perle contenant un comonomère, l'acrylate de méthyle à hauteur de 6% en poids. Ce PMMA ne contient pas d'additif choc.
TiO₂: dioxyde de titane Ti-Pure® R 960 de la société DuPont et utilisé. Le diamètre moyen des particules selon le fournisseur est 0.5µm.

### Exemple 1 (selon l'invention)

Un film à trois couches A/B/A est constitué :
- d'une couche de 5µm d'épaisseur contenant 100% de PVDF-1, et
- d'une couche de 20µm d'épaisseur contenant en poids 60% de PVDF-2, 24% de PMMA et 16% de TiO₂, et
- d'une couche de 5µm d'épaisseur contenant 100% de PVDF-1.

### Exemple 2 (selon l'invention)

Un film à trois couches A/B/A est constitué :
- d'une couche de 5µm d'épaisseur contenant 100% de PVDF-1, et
- d'une couche de 20µm d'épaisseur contenant en poids 60% de PVDF-1, 24% de PMMA et 16% de TiO₂, et
- d'une couche de 5µm d'épaisseur contenant 100% de PVDF-1.

### Exemple 3 (selon l'invention)

Un film à trois couches A/B/A est constitué :
- d'une couche de 5µm d'épaisseur contenant 100% de PVDF-1, et
- d'une couche de 20µm d'épaisseur contenant en poids 60% de PVDF-3, 24% de PMMA et 16% de TiO₂, et
- d'une couche de 5µm d'épaisseur contenant 100% de PVDF-1.

### Exemple 4 (selon l'invention)

Un film à trois couches A/B/A est constitué :
- d'une couche de 5µm d'épaisseur contenant 100% de PVDF-1, et
- d'une couche de 15µm d'épaisseur contenant en poids 50% de PVDF-3, 30% de PMMA et 20% de TiO₂, et
- d'une couche de 5µm d'épaisseur contenant 100% de PVDF-1.

### Exemple 5 (selon l'invention)

Un film à trois couches A/B/A est constitué :
- d'une couche de 5µm d'épaisseur contenant 100% de PVDF-1, et
- d'une couche de 15µm d'épaisseur contenant en poids 40% de PVDF-3, 36% de PMMA et 24% de TiO₂, et
- d'une couche de 5µm d'épaisseur contenant 100% de PVDF-1.

### Exemple 6 (selon l'invention)

Un film à trois couches A/B/A est constitué :
- d'une couche de 5µm d'épaisseur contenant 100% de PVDF-1, et
- d'une couche de 20µm d'épaisseur contenant en poids 40% de PVDF-3, 36% de PMMA et 24% de TiO₂, et
- d'une couche de 5µm d'épaisseur contenant 100% de PVDF-1.

### Exemple 7 (selon l'invention)

Un film à trois couches A/B/A est constitué :
- d'une couche de 8µm d'épaisseur contenant 100% de PVDF-1, et
- d'une couche de 20µm d'épaisseur contenant en poids 60% de PVDF-3, 24% de PMMA et 16% de TiO₂, et
- d'une couche de 8µm d'épaisseur contenant 100% de PVDF-1.

### Exemple 8 (exemple comparatif)

Un film à deux couches est constitué :
- d'une couche de 10µm d'épaisseur contenant 100% de PVDF-1, et
- d'une couche de 20µm d'épaisseur contenant en poids 60% de PVDF-2, 24% de PMMA et 16% de TiO₂.

### Exemple 9 (exemple comparatif)

Un film à trois couches A/B/C est constitué :
- d'une couche de 10µm d'épaisseur contenant 100% de PVDF-1, et
- d'une couche de 20µm d'épaisseur contenant en poids 60% de PVDF-2, 24% de PMMA et 16% de TiO₂, et
- d'une couche de 5µm d'épaisseur contenant en poids 30% de PVDF-2 et 70% de PMMA

### Exemple 10 (exemple comparatif)

Un film à trois couches A/B/C est constitué :
- d'une couche de 5µm d'épaisseur contenant 100% de PVDF-1, et
- d'une couche de 20µm d'épaisseur contenant en poids 60% de PVDF-2, 24% de PMMA et 16% de TiO₂, et
- d'une couche de 5µm d'épaisseur contenant 100% de PVDF-4

### Exemple 11 (selon l'invention)

Un film à trois couches A/B/A est constitué :
- d'une couche de 5µm d'épaisseur contenant 100% de PVDF-1, et
- d'une couche de 30µm d'épaisseur contenant en poids 60% de PVDF-1, 24% de PMMA et 16% de TiO₂, et
- d'une couche de 5µm d'épaisseur contenant 100% de PVDF-1.

### Exemple 12 (selon l'invention)

Un film à trois couches A/B/A est constitué :
- d'une couche de 5µm d'épaisseur contenant 100% de PVDF-1, et
- d'une couche de 10µm d'épaisseur contenant en poids 60% de PVDF-1, 24% de PMMA et 16% de TiO₂, et
- d'une couche de 5µm d'épaisseur contenant 100% de PVDF-1.

Les films de ces exemples ont les propriétés suivantes :

Dans le cas où la composition A de première couche est identique à la composition C de troisième couche, la résistance thermique n'est présentée que pour la composition A.

| Exemple | Opacité UV | Transmittance[%] | Résistance chimique à la MEC | Résistance thermique du film DSC | | | Retrait film à 150°C [%] |
|---|---|---|---|---|---|---|---|
| | ARKEMA method | ASTM D1003 (ill. D65) | EN 438-2 | ISO 11357-3 (20°C/min) | | | ISO 11501 |
| | | | | Tf (A) [°C] | Tf (B) [°C] | Tf (C) [°C] | |
| 1 | ++ | 19 | 4 | 165 | 142 | - | <1 |
| 2 | ++ | 18 | 4 | 165 | 167 | - | <0.5 |
| 3 | ++ | 19 | 4 | 165 | 162 | - | <0.5 |
| 4 | + | 23 | 4 | 165 | *160* | - | <0.5 |
| 5 | ++ | 21 | 4 | 165 | *158* | - | <0.5 |
| 6 | ++ | 17 | 5 | 166 | 162 | - | <0.5 |
| 7 | +++ | 16 | 4 | 165 | *158* | - | <0.5 |
| Comp. 8 | ++ | 19 | 1 (a) | 167 | 142 | - | 5 |
| Comp 9 | ++ | 18 | 1 (b) | 167 | 142 | NA (c) | 5 |
| Comp. 10 | ++ | 19 | 2 (b) | 165 | 142 | 135 | 2 |
| 11 | +++ | 13 | 4 | 169 | 167 | | <0.5 |
| 12 | + | 24 | 4 | 169 | 167 | | <0.5 |

| | | | | | | | |
|---|---|---|---|---|---|---|---|
| (a) La résistance chimique est mesurée côté couche B (b) La résistance chimique est mesurée côté couche C (c) Pas d'enthalpie de fusion, la transition vitreuse est mesurée à 50°C (selon ISO 11357-2) | | | | | | | |

Les structures sous forme des films A/B/A dans des exemples selon l'invention ont une très bonne résistance chimique et un faible retrait (stabilité dimensionnelle du film) à 150°C.

## Revendications

1. Film multicouche de structure A/B/C consistant en:
• une première couche de composition A comprenant 100% massique d'un homopolymère de VDF;
• une seconde couche de composition B consistant en : de 30 à 75 parties d'un homopolymère ou copolymère de VDF contenant au plus 11% massique de comonomère, de 5 à 45 parties d'un homopolymère ou copolymère de MMA et de 10 à 30 parties de TiO₂, le total faisant 100 parties ; et
• une troisième couche de composition C comprenant 100% d'un homopolymère de VDF,
dans lequel :
- la première et troisième couches présentent un point de fusion supérieur à 150°C mesuré par DSC,
- la transmittance à la lumière visible est inférieure à 30% pour une épaisseur du film multicouche de 25µm,
- l'épaisseur de chacune des couches de composition A et C est, de manière indépendante l'une de l'autre, comprise entre 1 et 30 µm, avantageusement entre 2 et 20 µm, préférentiellement entre 3 et 18 µm et de manière encore plus préférée entre 5 et 15µm, et
- l'épaisseur de la couche de composition B est comprise entre 7 et 30 µm, de préférence entre 10 et 25µm.

2. Film multicouche selon la revendication 1, **caractérisé en ce que** le retrait dimensionnel à 150°C du film est inférieur à 1%.

3. Film multicouche selon l'une des revendications 1 et 2, **caractérisé en ce que** le polymère fluoré de la seconde couche contient un taux massique de comonomère, au plus égal à 10%.

4. Film multicouche selon l'une des revendications précédentes, **caractérisé en ce que** le polymère fluoré de la seconde couche a un point fusion supérieur à 140°C mesure par DSC.

5. Film multicouche selon l'une des revendications précédentes, **caractérisé en ce que** la teneur en charge dans la composition B est comprise entre 10 et 27% massique et de manière encore plus préférée entre 15 et 25%.

6. Film multicouche selon l'une des revendications précédentes, **caractérisé en ce que** la taille de la charge est comprise entre 0,05µm et 1mm.

7. Film multicouche selon l'une des revendications précédentes, **caractérisé en ce que** le polymère fluoré de la seconde couche est un copolymère de VDF.

8. Utilisation d'un film multicouche selon l'une des revendications précédentes dans une cellule photovoltaïque, un textile technique ou sur un métal.

9. Cellule photovoltaïque comprenant dans le panneau arrière de la dite cellule assemblée un film selon l'une des revendications 1 à 7.

## Patentansprüche

1. Mehrschichtfolie der Struktur A/B/C, bestehend aus:
• einer ersten Schicht der Zusammensetzung A, die 100 Gew.-% eines Homopolymers von VDF enthält;
• einer zweiten Schicht der Zusammensetzung B, die aus 30 bis 75 Teilen eines Homopolymers oder Copolymers von VDF, worin höchstens 11 Gew.-% Comonomer enthalten sind, 5 bis 45 Teilen eines Homopolymers oder Copolymers von MMA und 10 bis 30 Teilen TiO₂ besteht, wobei die Summe 100 Teile ausmacht; und
• einer dritten Schicht der Zusammensetzung C, die 100 % eines Homopolymers von VDF enthält;
**dadurch gekennzeichnet, dass**
- die erste und die dritte Schicht einen mit DSC gemessenen Schmelzpunkt über 150 °C aufweisen,
- die Transmission für sichtbares Licht bei einer Dicke der Mehrschichtfolie von 25 µm unter 30 % liegt,
- die Dicke jeder der Schichten der Zusammensetzung A und C unabhängig voneinander zwischen 3 und 30 µm, vorteilhaft zwischen 2 und 20 µm, bevorzugt zwischen 3 und 18 µm und noch bevorzugter zwischen 5 und 15 µm liegt, und
- die Dicke der Schicht der Zusammensetzung B zwischen 7 und 30 µm und noch bevorzugter zwischen 10 und 25 µm liegt.

2. Mehrschichtfolie nach Anspruch 1, **dadurch gekennzeichnet, dass** die dimensionelle Schrumpfung der Folie bei 150 °C unter 1 % liegt.

3. Mehrschichtfolie nach einem der Ansprüche 1 oder 2, **dadurch gekennzeichnet, dass** das Fluorpolymer der zweiten Schicht höchstens 10 Gew.-% Comonomer enthält.

4. Mehrschichtfolie nach einem der vorhergehenden Ansprüche, **dadurch gekennzeichnet, dass** das Fluorpolymer der zweiten Schicht einen mit DSC gemessenen Schmelzpunkt über 140 °C aufweist.

5. Mehrschichtfolie nach einem der vorhergehenden Ansprüche, **dadurch gekennzeichnet, dass** der Mengenanteil des Füllstoffes in der Zusammensetzung B zwischen 10 und 27 Gew.-% und vorzugsweise zwischen 15 und 25 Gew.-% liegt.

6. Mehrschichtfolie nach einem der vorhergehenden Ansprüche, **dadurch gekennzeichnet, dass** die Größe des Füllstoffes im Bereich von 0,05 µm bis 1 mm liegt.

7. Mehrschichtfolie nach einem der vorhergehenden Ansprüche, **dadurch gekennzeichnet, dass** das Fluorpolymer der zweiten Schicht ein VDF-Copolymer ist.

8. Verwendung einer Mehrschichtfolie nach einem der vorhergehenden Ansprüche in einer Photovoltaikzelle, einem technischen Textil oder auf einem Metall.

9. Photovoltaikzelle, die in der Rückwand der montierten Zelle eine Folie nach einem der Ansprüche 1 bis 7 aufweist.

## Claims

1. Multilayer film of A/B/C structure comprising:
• a first layer of composition A comprising 100 wt% of a homopolymer of VDF;
• a second layer of composition B consisting of 30 to 75 parts of a homopolymer or copolymer of VDF containing at most equal to 11 wt% of comonomer, from 5 to 45 parts of a homopolymer or copolymer of MMA and from 10 to 30 parts of TiO₂, the total making 100 parts; and
• a third layer of composition C comprising 100 wt% of a homopolymer of VDF,
**characterized in that**:
- the first and third layers have a melting point above 150°C measured by DSC,
- the visible light transmittance is less than 30% for a multilayer film thickness of 25 µm,
- the thickness of each of the layers of composition A and C is, independently of one another, between 1 and 30 µm, advantageously between 2 and 20 µm, preferably between 3 and 18 µm and more preferably still between 5 and 15 µm, and
- the thickness of the layer of composition B is between 7 and 30 µm and more preferably still between 10 and 25 µm.

2. Multilayer film according to Claim 1, **characterized in that** the dimensional shrinkage of the film at 150°C is less than 1 %.

3. Multilayer film according to one of Claims 1 or 2, **characterized in that** the fluoropolymer of the second layer contains at most equal to 10 wt% of comonomer.

4. Multilayer film according to one of the preceding claims, **characterized in that** the fluoropolymer of the second layer has a melting point above 140°C measured by DSC.

5. Multilayer film according to one of the preceding claims, **characterized in that** the filler content in the composition B is between 10 and 27 wt% and preferably between 15 and 25 wt%.

6. Multilayer film according to one of the preceding claims, **characterized in that** the size of the filler is between 0.05 µm and 1 mm.

7. Multilayer film according to one of the preceding claims, **characterized in that** the fluoropolymer of the second layer is a copolymer of VDF.

8. Use of a multilayer film according to one of the preceding claims in a photovoltaic cell, a technical textile or on a metal.

9. Photovoltaic cell comprising, in the rear panel of said assembled cell, a film according to one of claims 1 to 7.
